# EUROPÄISCHE PATENTSCHRIFT

(11) **EP 3 317 966 B1**
(45) Veröffentlichungstag und Bekanntmachung des Hinweises auf die Patenterteilung: **07.08.2019**
(21) Anmeldenummer: 16740974.7
(22) Anmeldetag: 30.06.2016
(51) Int. Cl.: H03F 3/193, H01F 27/28, H01J 37/32, H03F 3/30, H03F 1/56, H03F 3/21, H03F 1/30, H05K 1/02, H05K 1/16, H05K 1/18

(54) **HOCHFREQUENZVERSTÄRKERANORDNUNG**
HIGH-FREQUENCY AMPLIFIER ARRANGEMENT
ENSEMBLE AMPLIFICATEUR HAUTE FRÉQUENCE

(30) Priorität: 30.06.2015 DE 102015212220
(43) Veröffentlichungstag der Anmeldung: 09.05.2018
(73) Patentinhaber: TRUMPF Hüttinger GmbH + Co. KG, 79111 Freiburg (DE)
(72) Erfinder: GREDE, André, 3018 Bern (CH); ALT, Alexander, Cardiff CF143UA (GB); GRUNER, Daniel, 79379 Muellheim (DE); LABANC, Anton, 79238 Ehrenkirchen (DE)
(74) Vertreter: Trumpf Patentabteilung
(86) Internationale Anmeldenummer: PCT/EP2016/065385
(87) Internationale Veröffentlichungsnummer: WO 2017/001602

(56) Entgegenhaltungen:
- CA-A1- 2 556 839
- JP-B2- 4 271 457
- US-A1- 2003 020 583
- US-A1- 2007 030 659
- US-A1- 2011 241 781
- US-A1- 2014 361 690
- US-B2- 7 768 371
- MAJID A ET AL: "High frequency half-bridge converter using multilayered coreless Printed Circuit Board step-down power transformer", POWER ELECTRONICS AND ECCE ASIA (ICPE&ECCE), 2011 IEEE 8TH INTERNATIONAL CONFERENCE ON, IEEE, 30. Mai 2011 (2011-05-30), Seiten 1177-1181, XP031956308, DOI: 10.1109/ICPE.2011.5944712 ISBN: 978-1-61284-958-4
- FREDERICK H RAAB ED - ANONYMOUS: "Broadband Class-E Power Amplifier for HF and VHF", MICROWAVE SYMPOSIUM DIGEST, 2006. IEEE MTT-S INTERNATIONAL, IEEE, PI, 1. Juni 2006 (2006-06-01), Seiten 902-905, XP031018618, ISBN: 978-0-7803-9541-1
- SCHAUWERS J-P ET AL: "Planar transformer technology applied to AC/DC conversion", TELECOMMUNICATION ENERGY CONFERENCE, 1999. INTELEC '99. THE 21ST INTER NATIONAL COPENHAGEN, DENMARK 6-9 JUNE 1999, PISCATAWAY, NJ, USA,IEEE, US, 6. Juni 1999 (1999-06-06), Seite 5pp, XP010351421, ISBN: 978-0-7803-5624-5
- CONCETTINA BUCCELLA ET AL: "A computational method of temperature distribution in high frequency planar transformers", INDUSTRIAL ELECTRONICS (ISIE), 2011 IEEE INTERNATIONAL SYMPOSIUM ON, IEEE, 27. Juni 2011 (2011-06-27), Seiten 477-482, XP032019032, DOI: 10.1109/ISIE.2011.5984072 ISBN: 978-1-4244-9310-4
- WANG Y A ET AL: "Design of a planar power transformer for high voltage, high frequency use", TRANSMISSION AND DISTRIBUTION CONFERENCE AND EXPOSITION, 2010 IEEE PES, IEEE, PISCATAWAY, NJ, USA, 19. April 2010 (2010-04-19), Seiten 1-6, XP031689148, ISBN: 978-1-4244-6546-0
- JAWAD SALEEM ET AL: "High frequency full bridge converter using multilayer coreless printed circuit board step up power transformer", CIRCUIT THEORY AND DESIGN (ECCTD), 2011 20TH EUROPEAN CONFERENCE ON, IEEE, 29. August 2011 (2011-08-29), Seiten 805-808, XP031975687, DOI: 10.1109/ECCTD.2011.6043837 ISBN: 978-1-4577-0617-2

## Beschreibung

Die Erfindung betrifft eine Hochfrequenzverstärkeranordnung, die geeignet ist, Ausgangsleistungen ≥ 1 kW bei Frequenzen ≥ 2 MHz zur Plasmaanregung zu erzeugen, umfassend:
a. zwei Transistoren, die mit ihrem Source- bzw. Emitteranschluss jeweils mit einem Masseverbindungspunkt verbunden sind, wobei die Transistoren gleichartig ausgebildet sind und an einer mehrlagigen Leiterkarte angeordnet sind,
b. einen Leistungsübertrager, dessen Primärwicklung mit den Drain- bzw. Kollektoranschlüssen der Transistoren verbunden ist.

Es ist bekannt, für die Erzeugung von Leistungen, die geeignet sind, ein Plasma anzuregen, Transistoren, insbesondere Bipolartransistoren oder LDMOS-Transistoren, einzusetzen. Zur Plasmaanregung ist es insbesondere wünschenswert, die Hochfrequenzverstärkeranordnung im Klasse F Verstärkerbetrieb oder in der Klasse F-Invers betreiben zu können. Hierbei kann es zu einer erheblichen Wärmeentwicklung kommen, insbesondere dann, wenn Leistung von einer Last reflektiert wird und in der Hochfrequenzverstärkeranordnung in Wärme umgesetzt werden muss. Unterschiedliche Verstärkeranordnungen werden z.B. in den folgenden Schriften gezeigt: US2009/0027936 A1, US2010/0148866 A1, US7,221,102 B2, US5,835,367 A, US2008/0272875 A1, US2013/0038226 A1, US2011/0241781, US2014/0361690.

Aufgabe der vorliegenden Erfindung ist es, eine Hochfrequenzverstärkeranordnung bereit zu stellen, die auch im Dauerstrichbetrieb ohne Lüfter auskommt.

Gelöst wird diese Aufgabe erfindungsgemäß durch eine Hochfrequenzverstärkeranordnung gemäß Anspruch 1. Diese ist geeignet, Ausgangsleistungen ≥ 1 kW bei Frequenzen ≥ 2 MHz zur Plasmaanregung zu erzeugen, und umfasst unter anderem:
a. zwei Transistoren, die mit ihrem Source- bzw. Emitteranschluss jeweils mit einem Masseverbindungspunkt verbunden sind, wobei die Transistoren gleichartig ausgebildet sind und an einer mehrlagigen Leiterkarte angeordnet sind,
b. einen Leistungsübertrager, dessen Primärwicklung mit den Drain- bzw. Kollektoranschlüssen der Transistoren verbunden ist,
c. wobei die Primärwicklung und die Sekundärwicklung des Leistungsübertragers jeweils als planare Leiterbahnen ausgeführt sind, die in unterschiedlichen oberen Lagen der mehrlagigen Leiterkarte angeordnet sind.

Als Transistoren sind dabei vorzugsweise zwei Bipolartransistoren oder zwei LDMOS-Transistoren vorgesehen. Diese eignen sich besonders für einen Pushpull-Betrieb.

Unter einer oberen Lage der mehrlagigen Leiterkarte wird dabei eine Lage verstanden, die nicht die unterste Lage der Leiterkarte ist. Die planaren Leiterbahnen der Primärwicklung und der Sekundärwicklung sind dabei vorzugsweise in das Leiterkartenmaterial eingebettet und befinden sich in unterschiedlichen Ebenen, d.h. sie sind voneinander beabstandet und zwischen den Leiterbahnen ist Leiterkartenmaterial angeordnet. Mit einer solchen Anordnung ist eine gute Wärmeabfuhr möglich. Weiterhin ist es mit einer solchen Anordnung möglich, dass im idealen Pushpull-Betrieb für "Differential Mode"-Signale die Grundwelle, d.h. das von der Hochfrequenzverstärkeranordnung erzeugte Hochfrequenzsignal bei einer vorgegebenen Grundfrequenz (die die Arbeitsfrequenz der Hochfrequenzverstärkeranordnung ist) und ungeradzahlige Harmonische ausschließlich im Gegentakt und geradzahlige Harmonische ausschließlich im Gleichtakt angeregt werden. Durch die Wahl des Windungsverhältnisses der Primärwicklung zur Sekundärwicklung kann bei der Grundfrequenz eine Impedanz für jeden der beiden Transistoren je nach gewünschtem Verhalten der Verstärkeranordnung zur Verfügung gestellt werden. Die geraden und ungeraden harmonischen Frequenzanteile, die bei der Anregung der Hochfrequenzverstärkeranordnung aufgrund von Nichtlinearitäten der Transistoren entstehen können, können bezüglich der Impedanz der Grundwelle mit einem höherreflektiven Abschluss abgeschlossen werden, um bei diesen Frequenzen weniger Energie umzusetzen und den Wirkungsgrad zu erhöhen. Ein höherreflektiver Abschluss für eine harmonische Frequenz ist ein Abschluss, der einen höheren Reflektionsfaktor aufweist, als der bei der Grundwelle. Ein höherreflektiver Abschluss kann zum Beispiel ein Kurzschluss oder ein Leerlauf für die entsprechende harmonische Frequenz sein. Dies kann durch zusätzliche auf die entsprechende harmonische Frequenz abgestimmte Filter erfolgen. Die Phase der Reflektionsfaktoren kann so gewählt werden, dass Strom- und Spannungswellenform an den Transistoren derart geformt werden, dass es zu einer minimalen Überlappung kommt. Somit entsteht eine verringerte Verlustleistung an den Transistoren.

Die Primär- und die Sekundärwicklung können vertikal miteinander gekoppelt sein. Durch den Abstand und des dazwischen liegende Material kann die Kopplung beeinflusst werden.

Dabei kann die Primärwicklung unter der Sekundärwicklung angeordnet sein.

Die Transistoren können in einem gemeinsamen Gehäuse angeordnet sein. Insbesondere kann vorgesehen sein, dass die Transistoren in einer Baugruppe (Package) angeordnet sind. Dadurch ergibt sich eine kompakte Bauweise und ein geringerer Herstellungsaufwand.

Der vertikale Abstand der Primärwicklung von der Sekundärwicklung kann kleiner sein als die halbe Breite einer Leiterbahn, aus der die Primärwicklung oder die Sekundärwicklung ausgebildet ist. Dadurch kann ein Kompromiss zwischen erhöhter magnetischer Kopplung (kleiner Abstand) und verringerter kapazitiver Kopplung (großer Abstand) erreicht werden.

Die unterste Lage der mehrlagigen Leiterkarte kann als metallische Schicht ausgebildet sein, die als Bezugsmasse dient. Diese metallische Schicht kann auch verwendet werden, um einen guten Wärmeübergang zu einer Kühlplatte herzustellen. Daher kann vorgesehen sein, dass die Leiterkarte auf einer metallischen Kühlplatte angeordnet ist.

Der vertikale Abstand der Primärwicklung und der Sekundärwicklung des Leistungsübertragers zur untersten Lage der Leiterkarte kann größer sein als der Abstand der Primärwicklung zu der Sekundärwicklung. Dadurch kann sichergestellt werden, dass der Kapazitätsbelag von den Lagen, in denen die Wicklungen angeordnet sind, zu Masse und die kapazitive Kopplung zwischen den Lagen, in denen die Wicklungen angeordnet sind, für das gewünschte Anpassverhalten, d.h. ideale Transformation, klein genug ist und andererseits auch der thermische Widerstand zur Kühlplatte klein genug ist, um Verluste in der Primärwicklung und der Sekundärwicklung Richtung Kühlplatte abführen zu können.

Die horizontale Erstreckung der Primärwicklung und der Sekundärwicklung in horizontaler Längsrichtung und in horizontaler Querrichtung der Leiterkarte kann jeweils < λ/30 sein, wobei λ die Wellenlänge des durch die Hochfrequenzverstärkeranordnung erzeugten Hochfrequenzsignals ist.

Es kann jeweils eine Kapazität, insbesondere ein Kondensator, parallel zur Primärwicklung und zur Sekundärwicklung des Leistungsübertragers geschaltet sein. Diese Kapazität, beispielweise ausgebildet als konzentrierter Kondensator, kann zusammen mit der jeweiligen Eigeninduktivität der Primärwicklung oder der Sekundärwicklung bei der Grundfrequenz eine hohe Impedanz darstellen, insbesondere nahe der Parallelresonanz. Auf der Primärseite des Leistungsübertragers kann diese Kapazität in Teilen aus der Ausgangskapazität des Transistors gebildet werden. Die Parallelkapazität auf der Primärseite kann sich weiterhin aus einer Kombination von Gegentaktkapazität zwischen den beiden Drains bzw. Kollektoren des Transistorpaars und den Gleichtaktkapazitäten jeweils von den beiden Drains bzw. Kollektoren in Richtung Masse zusammensetzen.

Die Primärwicklung kann symmetrisch ausgestaltet werden, so dass die Primärseite für beide Transistoren dieselbe Last zeigt. Dadurch entsteht ein hochohmiger Abschluss im Vergleich zur Grundwellenimpedanz, so dass zweite Harmonische bei Gleichtaktanregung hochohmig belastet ist.

Die Windungszahlen für die Primärwicklung und die Sekundärwicklung des Leistungsübertragers können so gewählt werden, dass eine gewünschte Impedanztransformation entsteht. Insbesondere kann das Windungszahlverhältnis 1:2 sein, bevorzugt kann die Primärwicklung eine Windung und die Sekundärwicklung zwei Windungen aufweisen.

Die Primärwicklung des Leistungsübertragers kann zur DC-Versorgung der Transistoren eine Mittelpunktanzapfung aufweisen.

An die Mittelpunktanzapfung kann ein Netzwerk mit einer Induktivität und/oder einem Kondensator angeschlossen sein. Dadurch können geradzahlige Harmonische terminiert werden. Eine Serienschaltung aus diesem Netzwerk und der halben Primärwicklung an der Mittelpunktanzapfung sollte für die doppelte Grundfrequenz hochohmig ausgelegt sein.

Die Drains bzw. Kollektoren der Transistoren sind durch eine Serienschaltung umfassend eine Induktivität und einen Kondensator verbunden. Bei dem Kondensator kann es sich um einen konzentrierten oder um einen verteilten Kondensator handeln. Die Serienschaltung aus Induktivität und Kondensator kann derart dimensioniert werden, dass bei der dritten Harmonischen ein niederohmiger Abschluss erzielt wird. Quantitativ kann so ein im Vergleich zur Grundwellenimpedanz niederohmiger Abschluss realisiert werden.

Die Induktivität der Serienschaltung kann als planare Induktivität auf einer oberen Lage der Leiterkarte ausgebildet sein. Die unterste Lage der Leiterkarte dient hier wiederum als Masselage und stellt einen niederohmigen Wärmepfad für die Verlustleistung in Richtung Kühlplatte dar.

Zur Ansteuerung der Transistoren kann ein Signalübertrager vorgesehen sein, dessen Sekundärwicklung mit einem ersten Ende mit dem Gate bzw. Basisanschluss des einen Transistors verbunden ist und mit einem zweiten Ende mit dem Gate bzw. Basisanschluss des anderen Transistors verbunden ist.

Höhere als vierte Harmonische haben auf die Leistung der Hochfrequenzverstärkeranordnung nur eine geringe Auswirkung. Optional können sie direkt an den Drains bzw. Kollektoren in Richtung Masse über jeweils einen Kondensator niederohmig verbunden werden. Auf diese Art und Weise kann die Anregung parasitärer Resonanzen durch sehr hohe Harmonische verhindert werden und kann die Stabilität maßgeblich verbessert werden.

Eine erfindungsgemäße Hochfrequenzanregungsanordnung ist geeignet, einen annähernd halbsinusförmigen Spannungsverlauf sowie einen annähernd rechteckförmigen Stromverlauf zu erzeugen. Dies entspricht einem Klasse F-Invers-Betrieb bzw. je nach Wahl der Grundwellenimpedanz und der entsprechenden Harmonischen einem Fall aus dem Klasse F-Invers-Kontinuum.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigen, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung in verschiedenen Stadien der Benutzung dargestellt und in der nachfolgenden Beschreibung näher erläutert.

Es zeigen.
- Fig. 1: ein Schaltbild einer erfindungsgemäßen Hochfrequenzverstärkeranordnung;
- Fig. 2: eine perspektivische Darstellung eines planaren Leistungsübertragers;
- Fig. 3: eine Schnittdarstellung durch eine Leiterkarte einer Hochfrequenzverstärkeranordnung;
- Fig. 4: Strom- und Spannungsverläufe, die sich an den Transistoren der Hochfrequenzverstärkeranordnung einstellen.

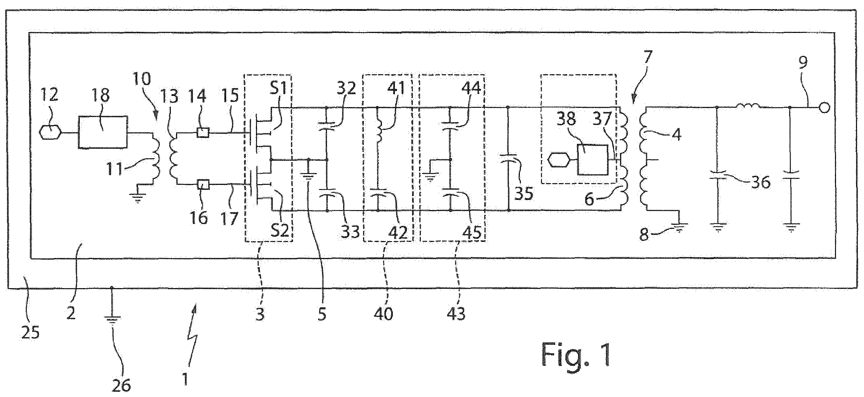

Die Figur 1 zeigt eine erste Ausführungsform einer Hochfrequenzverstärkeranordnung 1. Die Hochfrequenzverstärkeranordnung 1 umfasst eine Leiterkarte 2, an der eine Baugruppe 3 angeordnet ist. Die Leiterkarte 2 kann eine Mehrlagenleiterkarte sein. Die Baugruppe 3 weist zwei als LDMOS-Transistoren ausgebildete Transistoren S1, S2 auf, die gleichartig ausgebildet sind und die mit ihrem Sourceanschluss jeweils mit einem Masseverbindungspunkt 5 verbunden sind. Die Baugruppe 3 kann auf einem Substrat angeordnet sein. Die Baugruppe 3 kann in einem Gehäuse angeordnet sein. Das Gehäuse der Baugruppe 3 kann in einer Durchgangsausnehmung in der Leiterkarte 2 angeordnet sein. Die Anschlüsse der Baugruppe 3 können auf der Leiterkarte 2 kontaktiert sein.

Mit ihren Drainanschlüssen sind die Transistoren S1, S2 jeweils mit einem Ende einer Primärwicklung 6 eines Leistungsübertragers 7, der Teil eines Ausgangsnetzwerks ist, verbunden. Die Sekundärwicklung 4 des Leistungsübertragers 7 ist zum einem mit Masse 8 und zum anderen mit einem Hochfrequenzausgang 9 verbunden.

Die Drainanschlüsse der Transistoren S1, S2 sind über jeweils einen Kondensator 32, 33 mit Masse verbunden. Diese Verbindung erfolgt über eine Durchkontaktierung in den Hitzeverteiler der Transistoren S1, S2.

Die Hochfrequenzverstärkeranordnung 1 weist weiterhin einen Signalübertrager 10 auf, der eine Primärwicklung 11 aufweist, die beispielsweise über ein Anpassnetzwerk 18 an einen Hochfrequenzeingang 12 angeschlossen ist. Die Sekundärwicklung 13 des Signalübertragers 10 ist zum einen über ein resistives Element 14, insbesondere einen Widerstand, mit dem Gateanschluss 15 des Transistors S1 verbunden. Zum anderen ist die Sekundärwicklung 13 über ein resistives Element 16, insbesondere einen Widerstand, mit dem Gateanschluss 17 des Transistors S2 verbunden. Die resistiven Elemente 14, 16 und die Sekundärwicklung 13 sind somit in Reihe geschaltet. Der Signalübertrager 10 ist ebenfalls auf der Leiterkarte 2 angeordnet, genauso wie der Leistungsübertrager 7.

Die Leiterkarte 2 liegt flächig auf einer Kühlplatte 25 auf, die ebenfalls mit Masse 26 verbindbar ist. Die Baugruppe 3 kann zur Kühlung auf einer Kupferplatte montiert sein. Die Kupferplatte kann zur Wärmeübertragung von der Baugruppe 3 zur Kühlplatte 25 , und insbesondere zur Wärmespreizung, dienen. Die Kupferplatte kann in der gleichen Durchgangsausnehmung in der Leiterkarte 2 angeordnet sein, wie die Baugruppe 3. Die Kupferplatte kann eine größere Fläche aufweisen, als die der Kühlplatte 25 zugewandte Fläche der Baugruppe 3. Die Durchgangsausnehmung kann stufig ausgestaltet sein, angepasst zu den Flächen der Kupferplatte und der Baugruppe 3.

Die Figur 1 zeigt weiterhin, dass parallel zur Primärwicklung 6 des Leistungsübertragers 7 eine Kapazität 35 vorgesehen ist. Parallel zur Sekundärwicklung 4 des Leistungsübertragers 7 ist ebenfalls eine Kapazität 36 vorgesehen.

Die Primärwicklung 6 des Leistungsübertragers 7 weist eine Mittelpunktanzapfung 37 auf, die zur DC-Versorgung der Transistoren S1, S2 dient. An die Mittelpunktanzapfung 37 ist ein Netzwerk 38 angeschlossen, das eine Induktivität und/oder einen Kondensator aufweisen kann. Insbesondere kann eine Serienschaltung aus einem Kondensator und einer Induktivität vorgesehen sein. Alternativ könnte eine Kapazität gegen Masse und eine serielle Induktivität vorgesehen sein.

Die Drains bzw. Kollektoren der Transistoren S1, S2 sind durch eine Serienschaltung 40, umfassend eine Induktivität 41 und einen Kondensator 42 verbunden. Diese Serienschaltung 40 dient als niederohmiger Abschluss der dritten Harmonischen.

Optional kann weiterhin ein Anpassnetzwerk 43 vorgesehen sein, welches zwei Kondensatoren 44, 45 aufweist, deren Verbindungspunkt mit Masse verbunden ist. Damit kann die Primärwicklung 6 des Leistungsübertragers 7 getunt werden.

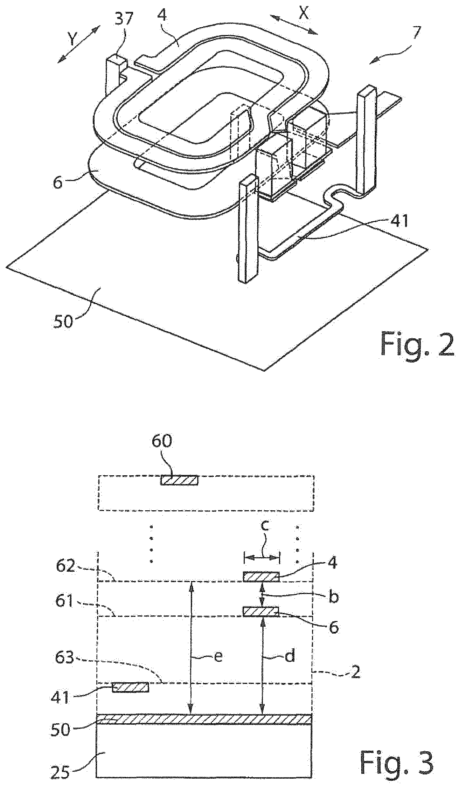

Figur 2 zeigt den Leistungsübertrager 7. Die Primärwicklung 6 ist unter der Sekundärwicklung 4 angeordnet. Die Primärwicklung 6 weist dabei eine Windung auf, während die Sekundärwicklung 4 zwei Windungen aufweist. Die Primärwicklung 6 und die Sekundärwicklung 4 nehmen in etwa die gleiche Fläche ein. Die Erstreckung in x-Richtung und in y-Richtung, d.h. in Längsrichtung und in Querrichtung der Leiterkarte 2, beträgt dabei jeweils weniger als λ/30, wobei λ die Wellenlänge des zu erzeugenden Hochfrequenzsignals ist. Es ist auch zu erkennen, dass die Primärwicklung 6 eine Mittelpunktanzapfung 37 aufweist (die Mittelpunktanzapfung 37 ist nicht mit der Sekundärwicklung 4 verbunden, was aus der Fig. 2 möglicherweise nicht so klar zu erkennen ist).

Sowohl die Primärwicklung 6 als auch die Sekundärwicklung 4 sind in oberen Lagen der Leiterkarte angeordnet. Insbesondere sind sie über einer unteren Lage 50 der Leiterkarte angeordnet. Der Figur 2 kann man auch entnehmen, dass die Primärwicklung 6 und die Sekundärwicklung 4 jeweils aus Leiterbahnen ausgebildet sind. In der Figur 2 ist weiterhin die planare Induktivität 41 zu sehen, die ebenfalls in einer Lage der Leiterkarte 2 angeordnet ist, sich jedoch über der Lage 50 befindet.

Die Figur 3 zeigt eine Schnittdarstellung durch eine Leiterkarte 2. Auf der Oberseite der Leiterkarte 2 sind Anschlusspads 60 zum Anschluss von diskreten Bauteilen vorgesehen. Entsprechende Anschlusspads könnten auch auf der Lage 62 sein. Die unterste Lage 50 der Leiterkarte 2 ist metallisch und flächig ausgebildet. Sie stellt eine Masseplatte dar und ist großflächig mit einer Kühlplatte 25 verbunden. In oberen Lagen 61, 62 der Leiterkarte sind die Primärwicklung 6 und die Sekundärwicklung 4 angeordnet. Der Abstand b zwischen der Primärwicklung 6 und der Sekundärwicklung 4 ist dabei vorzugsweise weniger als die Hälfte der Breite c einer Leiterbahn der Primärwicklung 6 oder der Sekundärwicklung 4. Der Abstand d von der Primärwicklung 6 zur Lage 50 und auch der Abstand e von der Sekundärwicklung 4 zur Lage 50 ist jeweils größer als der Abstand b. In der Lage 63 können Verbindungsleitungen und auch die planare Induktivität 41 vorgesehen sein.

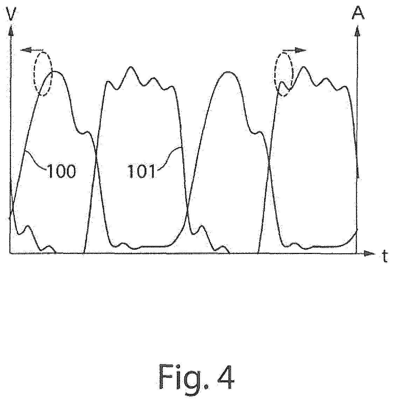

Die Figur 4 zeigt einen Spannungsverlauf 100, der nahezu halbsinusförmig ist und einen Stromverlauf 101, der im Wesentlichen rechteckförmig ist. Die Spannungs- bzw. Stromverläufe 100, 101 stellen sich an den Transistoren S1, S2 ein, wenn die Hochfrequenzverstärkeranordnung 1 richtig abgestimmt ist. Dabei ist zu erkennen, dass sich der Spannungsverlauf 100 und der Stromverlauf 101 nur geringfügig überlappen, was zur Folge hat, dass in den Transistoren S1, S2 nur eine geringe Wärmeleistung erzeugt wird.

## Patentansprüche

1. Hochfrequenzverstärkeranordnung (1), die geeignet ist, Ausgangsleistungen ≥ 1kW bei Frequenzen ≥ 2MHz zur Plasmaanregung zu erzeugen, umfassend:
a. zwei Transistoren (S1, S2), die mit ihrem Source- bzw. Emitteranschluss jeweils mit einem Masseverbindungspunkt (5) verbunden sind, wobei die Transistoren (S1, S2) gleichartig ausgebildet sind und an einer mehrlagigen Leiterkarte (2) angeordnet sind,
b. einen Leistungsübertrager (7), dessen Primärwicklung (6) mit den Drain- bzw. Kollektoranschlüssen der Transistoren (S1, S2) verbunden ist,
**dadurch gekennzeichnet, dass**
c. die Primärwicklung (6) und die Sekundärwicklung (4) des Leistungsübertragers (7) jeweils als planare Leiterbahnen ausgeführt sind, die in unterschiedlichen oberen Lagen (61, 62) der mehrlagigen Leiterkarte (2) angeordnet sind, und
d. die Drains bzw. Kollektoren der Transistoren (S1, S2) durch eine Serienschaltung (40) umfassend eine Induktivität (41) und einen Kondensator (42) verbunden sind.

2. Hochfrequenzverstärkeranordnung nach Anspruch 1, **dadurch gekennzeichnet, dass** die Primär- und die Sekundärwicklung (6, 4) vertikal miteinander gekoppelt sind.

3. Hochfrequenzverstärkeranordnung nach einem der vorhergehenden Ansprüche, **dadurch gekennzeichnet, dass** die Transistoren (S1, S2) in einem gemeinsamen Gehäuse angeordnet sind.

4. Hochfrequenzverstärkeranordnung nach einem der vorhergehenden Ansprüche, **dadurch gekennzeichnet, dass** der vertikale Abstand (b) der Primärwicklung (6) von der Sekundärwicklung (4) kleiner ist als die halbe Breite (c) einer Leiterbahn, aus der die Primärwicklung (6) oder die Sekundärwicklung (4) ausgebildet ist.

5. Hochfrequenzverstärkeranordnung nach einem der vorhergehenden Ansprüche, **dadurch gekennzeichnet, dass** die unterste Lage (50) der mehrlagigen Leiterkarte (2) als metallische Schicht ausgebildet ist, die als Bezugsmasse dient.

6. Hochfrequenzverstärkeranordnung nach einem der vorhergehenden Ansprüche, **dadurch gekennzeichnet, dass** die Leiterkarte (2) auf einer metallischen Kühlplatte (25) angeordnet ist.

7. Hochfrequenzverstärkeranordnung nach einem der vorhergehenden Ansprüche, **dadurch gekennzeichnet, dass** der vertikale Abstand (d, e) der Primärwicklung (6) und der Sekundärwicklung (4) des Leistungsübertragers (7) zur untersten Lage (50) der Leiterkarte (2) größer ist als der Abstand (b) der Primärwicklung (6) zu der Sekundärwicklung (4).

8. Hochfrequenzverstärkeranordnung nach einem der vorhergehenden Ansprüche, **dadurch gekennzeichnet, dass** die horizontale Erstreckung der Primärwicklung (6) und der Sekundärwicklung (4) in horizontaler Längsrichtung und in horizontaler Querrichtung der Leiterkarte (2) jeweils < λ /30 ist, wobei λ die Wellenlänge des durch die Hochfrequenzverstärkeranordnung erzeugten Hochfrequenzsignals ist.

9. Hochfrequenzverstärkeranordnung nach einem der vorhergehenden Ansprüche, **dadurch gekennzeichnet, dass** jeweils eine Kapazität (35, 36) parallel zur Primärwicklung (6) und zur Sekundärwicklung (4) des Leistungsübertragers (7) geschaltet ist.

10. Hochfrequenzverstärkeranordnung nach einem der vorhergehenden Ansprüche, **dadurch gekennzeichnet, dass** die Primärwicklung (6) des Leistungsübertragers (7) zur DC-Versorgung der Transistoren (S1, S2) eine Mittelpunktanzapfung (37) aufweist.

11. Hochfrequenzverstärkeranordnung nach Anspruch 10, **dadurch gekennzeichnet, dass** an der Mittelpunktanzapfung (37) ein Netzwerk (38) mit einer Induktivität und/oder einem Kondensator angeschlossen ist.

12. Hochfrequenzverstärkeranordnung nach einem der vorhergehenden Ansprüche, **dadurch gekennzeichnet, dass** die Induktivität (41) als planare Induktivität auf einer oberen Lage (63) der Leiterkarte (2) ausgebildet ist.

13. Hochfrequenzverstärkeranordnung nach einem der vorhergehenden Ansprüche, **dadurch gekennzeichnet, dass** ein Signalübertrager (10) vorgesehen ist, dessen Sekundärwicklung (13) mit einem ersten Ende mit dem Gate- bzw. Basisanschluss (15) des einen Transistors (S1) verbunden ist und mit einem zweiten Ende mit dem Gate- bzw. Basisanschluss (17) des anderen Transistors (S2) verbunden ist.

14. Hochfrequenzverstärkeranordnung nach einem der vorhergehenden Ansprüche, **dadurch gekennzeichnet, dass** als Transistoren (S1, S2) LDMOS-Transistoren vorgesehen sind.

15. Hochfrequenzverstärkeranordnung nach einem der vorhergehenden Ansprüche, **dadurch gekennzeichnet, dass** die Drains bzw. Kollektoren beider Transistoren (S1, S2) über jeweils einen Kondensator (32, 33) mit Masse verbunden sind.

## Claims

1. A high-frequency amplifier arrangement (1) suitable for generating output powers ≥ 1 kW at frequencies ≥ 2 MHz for plasma excitation, comprising:
a. two transistors (S1, S2) each having its source or emitter terminal connected to an earthing point (5), wherein the transistors (S1, S2) are of the same design and are arranged on a multilayer printed circuit board (2),
b. a power transformer (7) whose primary winding (6) is connected to the drain or collector terminals of the transistors (S1, S2),
**characterised in that**
c. the primary winding (6) and the secondary winding (4) of the power transformer (7) are each designed as planar strip conductors which are arranged in different upper layers (61, 62) of the multilayer printed circuit board (2), and
d. the drains or collectors of the transistors (S1, S2) are connected by a series circuit (40) comprising an inductor (41) and a capacitor (42).

2. The high-frequency amplifier arrangement according to claim 1, **characterised in that** the primary and the secondary winding (6, 4) are vertically coupled together.

3. The high-frequency amplifier arrangement according to one of the preceding claims, **characterised in that** the transistors (S1, S2) are arranged in a common housing.

4. The high-frequency amplifier arrangement according to one of the preceding claims, **characterised in that** the vertical distance (b) of the primary winding (6) from the secondary winding (4) is smaller than half the width (c) of a strip conductor from which the primary winding (6) or the secondary winding (4) is formed.

5. The high-frequency amplifier arrangement according to one of the preceding claims, **characterised in that** the lowermost layer (50) of the multilayer printed circuit board (2) is formed as a metal layer which serves as a reference earth.

6. The high-frequency amplifier arrangement according to one of the preceding claims, **characterised in that** the printed circuit board (2) is arranged on a metal cooling plate (25).

7. The high-frequency amplifier arrangement according to one of the preceding claims, **characterised in that** the vertical distance (d, e) of the primary winding (6) and the secondary winding (4) of the power transformer (7) to the lowermost layer (50) of the printed circuit board (2) is greater than that distance (b) of the primary winding (6) to the secondary winding (4).

8. The high-frequency amplifier arrangement according to one of the preceding claims, **characterised in that** the horizontal extent of the primary winding (6) and the secondary winding (4) in the horizontal longitudinal direction and in the horizontal transverse direction of the printed circuit board (2) is in each case < λ/30, where λ is the wavelength of the high-frequency signal generated by the high-frequency amplifier arrangement.

9. The high-frequency amplifier arrangement according to one of the preceding claims, **characterised in that** in each case one capacitor (35, 36) is connected in parallel with the primary winding (6) and with the secondary winding (4) of the power transformer (7).

10. The high-frequency amplifier arrangement according to one of the preceding claims, **characterised in that** the primary winding (6) of the power transformer (7) has a centre tap (37) to supply DC to the transistors (S1, S2).

11. The high-frequency amplifier arrangement according to claim 10, **characterised in that** a network (38) having an inductor and/or a capacitor is connected to the centre tap (37).

12. The high-frequency amplifier arrangement according to one of the preceding claims, **characterised in that** the inductor (41) is designed as a planar inductor on an upper layer (63) of the printed circuit board (2).

13. The high-frequency amplifier arrangement according to one of the preceding claims, **characterised in that** a signal transformer (10) is provided whose secondary winding (13) is connected at a first end to the gate or base terminal (15) of one of the transistors (S1) and is connected at a second end to the gate or base terminal (17) of the other transistor (S2).

14. The high-frequency amplifier arrangement according to one of the preceding claims, **characterised in that** LDMOS transistors are provided as transistors (S1, S2).

15. The high-frequency amplifier arrangement according to one of the preceding claims, **characterised in that** the drains or collectors of both transistors (S1, S2) are connected to earth via respective capacitors (32, 33).

## Revendications

1. Ensemble amplificateur haute fréquence (1) apte à générer des puissances de sortie ≥ 1 kW à des fréquences ≥ 2 MHz pour l'excitation d'un plasma, comprenant :
a. deux transistors (S1, S2), connectés par leur borne source et respectivement émettrice à un point de connexion à la masse (5), les transistors (S1, S2) étant de conception similaire et agencés sur une carte de circuit imprimé multicouche (2),
b. un transmetteur de puissance (7) dont l'enroulement primaire (6) est connecté aux bornes de drain et respectivement de collecteur des transistors (S1, S2), **caractérisé en ce que**
c. l'enroulement primaire (6) et l'enroulement secondaire (4) du transmetteur de puissance (7) sont conçus chacun sous la forme de pistes conductrices planes qui sont disposées dans différentes couches supérieures (61, 62) de la carte de circuit imprimé multicouche (2) et
d. les drains ou collecteurs des transistors (S1, S2) sont connectés par un circuit série (40) comprenant une inductance (41) et un condensateur (42).

2. Ensemble amplificateur haute fréquence selon la revendication 1, **caractérisé en ce que** l'enroulement primaire et l'enroulement secondaire (6, 4) sont couplés verticalement l'un à l'autre.

3. Ensemble amplificateur haute fréquence selon l'une des revendications précédentes, **caractérisé en ce que** les transistors (S1, S2) sont disposés dans un boîtier commun.

4. Ensemble amplificateur haute fréquence selon l'une des revendications précédentes, **caractérisé en ce que** la distance verticale (b) de l'enroulement primaire (6) par rapport à l'enroulement secondaire (4) est inférieure à la moitié de la largeur (c) d'une piste conductrice à partir de laquelle l'enroulement primaire (6) ou l'enroulement secondaire (4) est formé.

5. Ensemble amplificateur haute fréquence selon l'une des revendications précédentes, **caractérisé en ce que** la couche la plus basse (50) de la carte de circuit imprimé multicouches (2) est réalisée sous la forme d'une couche métallique servant de masse de référence.

6. Ensemble amplificateur haute fréquence selon l'une des revendications précédentes, **caractérisé en ce que** la carte de circuit imprimé (2) est disposée sur une plaque de refroidissement métallique (25).

7. Ensemble amplificateur haute fréquence selon l'une des revendications précédentes, **caractérisé en ce que** la distance verticale (d, e) de l'enroulement primaire (6) et de l'enroulement secondaire (4) du transmetteur de puissance (7) par rapport à la couche la plus basse (50) de la carte de circuit imprimé (2) est supérieure à la distance (b) de l'enroulement primaire (6) à l'enroulement secondaire (4).

8. Ensemble amplificateur haute fréquence selon l'une des revendications précédentes, **caractérisé en ce que** l'étendue horizontale de l'enroulement primaire (6) et de l'enroulement secondaire (4) est <λ / 30 respectivement dans le sens longitudinal horizontal et dans le sens transversal horizontal de la carte de circuit imprimé (2), où À est la longueur d'onde du signal de haute fréquence généré par l'ensemble amplificateur haute fréquence.

9. Ensemble amplificateur haute fréquence selon l'une des revendications précédentes, **caractérisé en ce qu'**un condensateur (35, 36) est respectivement connecté en parallèle à l'enroulement primaire (6) et à l'enroulement secondaire (4) du transmetteur de puissance (7).

10. Ensemble amplificateur haute fréquence selon l'une des revendications précédentes, **caractérisé en ce que** l'enroulement primaire (6) du transmetteur de puissance (7) pour l'alimentation en courant continu des transistors (S1, S2) présente une prise médiane (37).

11. Ensemble amplificateur haute fréquence selon la revendication 10, **caractérisé en ce qu'**un réseau (38) comportant une inductance et/ou un condensateur est connecté à la prise médiane (37).

12. Ensemble amplificateur haute fréquence selon l'une des revendications précédentes, **caractérisé en ce que** l'inductance (41) est conçue comme une inductance plane sur une couche supérieure (63) de la carte de circuit imprimé (2).

13. Ensemble amplificateur haute fréquence selon l'une des revendications précédentes, **caractérisé en ce qu'**il est prévu un émetteur de signal (10) dont l'enroulement secondaire (13) est connecté par une première extrémité à la borne de grille et respectivement de base (15) d'un transistor (S1) et par une deuxième extrémité, à la borne de grille et respectivement de base (17) de l'autre transistor (S2).

14. Ensemble amplificateur haute fréquence selon l'une des revendications précédentes, **caractérisé en ce que** des transistors LDMOS sont prévus en tant que transistors (S1, S2).

15. Ensemble amplificateur haute fréquence selon l'une des revendications précédentes, **caractérisé en ce que** les drains et respectivement les collecteurs des deux transistors (S1, S2) sont reliés à la masse par un condensateur respectif (32, 33).
